# FASCICULE DE BREVET EUROPEEN

(11) **EP 0 757 423 B1**
(45) Date de publication et mention de la délivrance du brevet: **12.01.2000**
(21) Numéro de dépôt: 96401720.6
(22) Date de dépôt: 02.08.1996
(51) Int. Cl.: H02K 11/04, H01L 25/11

(54) **Alternateur comportant des pièces d'adaptation pour diodes de pont redresseur, notamment pour véhicule automobile, et pièce d'adaptation pour un tel alternateur**
Wechselstromgenerator mit Anpassstücke für Gleichrichterdioden, insbesondere für Kraftwagengeneratoren, und Anpassstücke für diesen Drehstromgenerator
Alternator comprising parts for adapting rectifying diodes, especially for car alternators, and adaptor parts for this alternator

(30) Priorité: 02.08.1995 FR 9509425
(43) Date de publication de la demande: 05.02.1997
(73) Titulaire: VALEO EQUIPEMENTS ELECTRIQUES MOTEUR, 94000 Créteil (FR)
(72) Inventeur: Gautier, Jean, 49124 St Barthelemy (FR)
(74) Mandataire: Le Forestier, Eric

(56) Documents cités:
- EP-A- 0 480 372
- DE-B- 1 256 303
- FR-A- 2 633 463
- PATENT ABSTRACTS OF JAPAN vol. 005, no. 059 (E-053), 22 Avril 1981 & JP-A-56 010938 (HITACHI LTD;OTHERS: 01), 3 Février 1981,

## Description

La présente invention concerne d'une façon générale les alternateurs de véhicules automobiles, et plus particulièrement un perfectionnement au montage d'un pont redresseur sur le palier arrière d'un tel alternateur.

De façon classique, un alternateur polyphasé comprend un pont redresseur constitué par un jeu de diodes côté positif et un jeu de diodes côté négatif. Les diodes côté positif sont montées sur un dissipateur positif, tandis que les diodes côté négatif sont montées directement dans le palier arrière, qui tient lieu de raccordement à la masse et de dissipateur.

Il existe deux grands types de montage de ces diodes : l'emmanchement et le soudage. Toutefois, lorsque les diodes côté négatif doivent être montées dans un palier arrière métallique, par exemple en alliage d'aluminium, l'opération de soudage est proscrite, car elle nécessiterait compte-tenu de la capacité calorifique du palier un apport de chaleur déraisonnable. Les diodes doivent donc nécessairement être emmanchées, ce qui est désavantageux notamment à cause du recours nécessaire à une presse, ou bien du fait le montage des diodes peut alors nécessiter deux techniques, une soudure pour les diodes positives et un emmanchement pour les diodes négatives.

Une solution à ce problème consiste à prévoir un dissipateur négatif sur lequel les diodes côté négatif sont soudées, et qui est rapporté sur le palier. Un alternateur conçu selon cette technique est connu, par exemple, du document DE-B-1 256 303.

Cette solution est également désavantageuse car elle nécessite une conception spécifique du palier et d'une pièce additionnelle, à savoir le dissipateur négatif rapporté, et augmente l'encombrement axial de l'alternateur.

Il résulte de la discussion qui précède que, suivant la technique retenue pour le montage des diodes négatives, il est nécessaire de recourir à deux paliers arrière de types différents, ce qui est également désavantageux notamment sur le plan de la normalisation de la fabrication.

La présente invention vise à pallier cet inconvénient et à permettre de recourir à un même palier arrière indifféremment pour un montage soudé des diodes négatives et pour un montage par emmanchement de ces diodes.

Ainsi, la présente invention propose selon un premier aspect un alternateur, notamment pour véhicule automobile, du type comprenant des moyens dissipateurs comprenant un ou plusieurs orifices conçus pour recevoir une ou plusieurs diodes par emmanchement, caractérisé en ce qu'il comprend une pièce d'adaptation emmanchée respectivement dans le ou chaque orifice et présentant la forme générale d'un disque possédant un contour permettant un tel emmanchement et au moins une face plane sur laquelle est soudée une diode à souder.

Préférentiellement, les moyens dissipateurs sont constitués par un palier arrière métallique de l'alternateur.

L'invention propose également une pièce d'adaptation pour un dissipateur de pont redresseur d'alternateur, notamment pour véhicule automobile, ladite pièce d'adaptation étant caractérisée en ce qu'elle présente la forme générale d'un d'un disque présentant un contour tel qu'elle puisse être emmanchée dans un orifice du dissipateur destiné à l'emmanchement d'une diode, et au moins une face plane permettant le soudage d'une diode à souder.

Ainsi, pour des diodes à emmancher, on emmanche celles-ci directement dans des orifices appropriés du palier arrière, de la façon traditionnelle. Et pour des diodes à souder, on commence par souder celles-ci sur les éléments d'adaptation, puis ces derniers, portant les diodes, sont emmanchés dans des orifices identiques. Dans les deux cas, la suite des opérations de montage de l'alternateur peut être rigoureusement la même.

Des aspects préférés, mais non limitatifs, de l'alternateur et de la pièce d'adaptation selon l'invention sont les suivants :
- la pièce comprend deux ; faces planes opposées permettant le soudage de l'un parmi deux types de diodes à souder.
- les deux faces planes opposées ont des diamètres différents.
- la pièce comprend une face plane unique de soudage et, du côté opposé, des creux ou reliefs de dissipation thermique.
- la ou chaque face plane est en retrait, en étant circoncrite par un bourrelet de centrage de la diode.
- il est prévu entre la ou chaque face plane et le bourrelet associé une gorge périphérique de limitation des contraintes de cisaillement lors de la soudure.

D'autres aspects, buts et avantages de la présente invention apparaîtront mieux à la lecture de la description détaillée suivante de formes de réalisation préférées de celle-ci, donnée à titre d'exemple non limitatif et faite en référence aux dessins annexés, sur lesquels :
la figure 1 est une vue à moitié en coupe axiale et à moitié en élévation de côté d'une pièce d'adaptation selon une première forme de réalisation de l'invention,
la figure 2 est une vue en coupe axiale d'une pièce d'adaptation selon une deuxième forme de réalisation de l'invention,
la figure 3 est une demi-vue de dessous de la pièce d'adaptation de la figure 2,
la figure 4 est une vue partielle en coupe axiale d'un alternateur à diodes de redressement emmanchées,
la figure 5 est une vue partielle en coupe axiale d'un alternateur à diodes de redressement soudées d'un premier type, et
la figure 6 est une vue partielle en coupe axiale d'un alternateur à diodes de redressement soudées d'un second type.

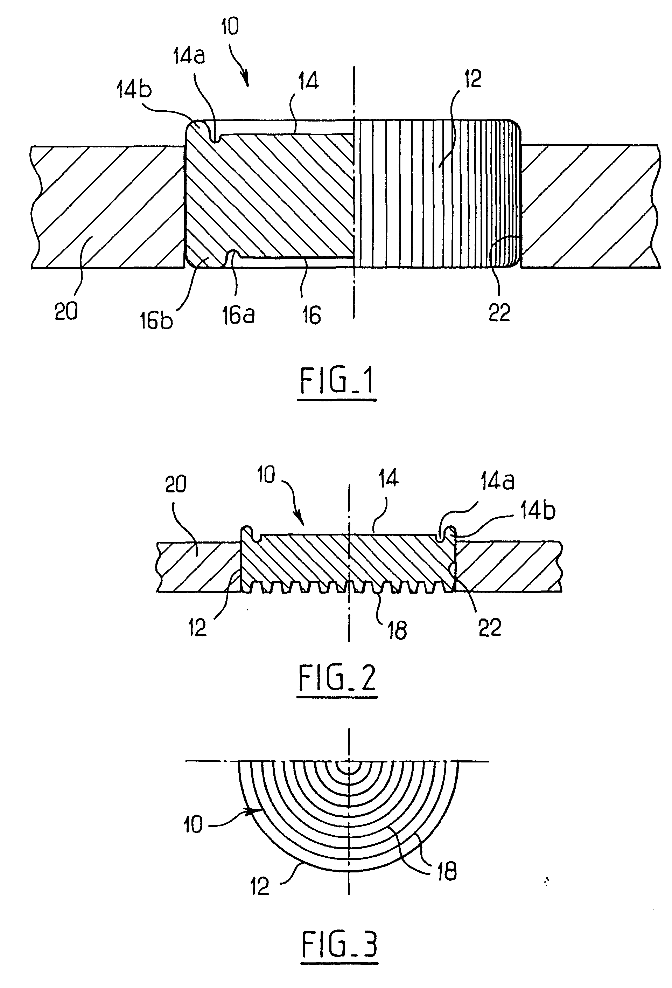

En référence tout d'abord à la figure 1, on a représenté une pièce d'adaptation selon l'invention, globalement indiquée en 10, qui présente la forme générale d'un disque épais et dont la circonférence 12 est munie de légères canelures axiales destinées à permettre son emmanchement à la presse dans un orifice d'un dissipateur destiné normalement à recevoir une diode de puissance du type à emmanchement à force. De préférence, le diamètre et la forme et la dimension des cannelures sont donc très voisins du diamètre et de la forme et de la dimension des canelures d'une telle diode de puissance.

La pièce 10 comporte une face supérieure plane 14 et une face inférieure plane 16. Chacune de ces faces est légèrement en retrait par rapport à la hauteur totale de la pièce, en étant circonscrite par un bourrelet périphérique, respectivement 14b, 16b. En outre, à la transition entre chaque face plane 14, 16 et le bourrelet associé 14b, 16b est prévue une gorge, respectivement 14a, 16a, de section relativement petite.

La face plane en creux 14 est de préférence dimensionnée, en termes de diamètre et profondeur, de manière à pouvoir recevoir, pour son soudage, une diode de puissance standard à souder de type communément désigné par "Button can".

La face plane en creux 16 est quant à elle de préférence dimensionnée, également en termes de diamètre et de profondeur, pour recevoir pour son soudage, à l'envers, une diode de puissance standard à souder de type communément désigné par "Potted can". Son diamètre est en conséquence légèrement inférieur à celui de la face 14.

On observera ici que les bourrelets périphériques 14b, 16b permettent d'assurer le centrage des types de diodes respectifs au moment de la soudure, tandis que les gorges 14a, 16a ont pour objet de limiter les contraintes de cisaillement sur les faces planes respectives 14, 16 sur lesquelles s'effectue la soudure.

La pièce d'adaptation 10 est réalisée de préférence en alliage de cuivre, aluminium ou laiton, avec un traitement de surface (étamage, etc...) permettant d'assurer la soudure de la diode et une protection contre la corrosion. La technique de fabrication peut être notamment l'usinage ou le moulage.

Ainsi la pièce 10 peut être utilisée pour le montage d'une diode de redressement à souder dans un orifice 22 d'un dissipateur, en particulier un palier arrière 20, d'un alternateur de véhicule, qui est initialement conçu pour recevoir une diode par emmanchement à la presse.

La pièce 10 est emmanchée à la presse dans l'orifice précité, dans un sens ou dans l'autre selon le type de diode à souder ("Button can" ou "Potted can").

Un même modèle de dissipateur peut donc être indifféremment utilisé :
pour des diodes standard à emmancher,
pour deux types différents de diodes à souder,
sans nécessiter une quelconque modification de conception.

En référence maintenant aux figures 2 et 3, on a représenté une deuxième forme de réalisation de la pièce d'adaptation de l'invention.

Elle comprend, outre les canelures circonférentielles 12, une seule face plane 14, entourée de sa gorge 14a et de son bourrelet 14b.

Sur sa face opposée, la pièce est munie d'une série de nervures concentriques 18. Cette face, après montage de la pièce dans un palier arrière d'alternateur, est exposée au flux d'air de ventilation interne de l'alternateur, et les nervures 18, ou tous autres reliefs ou creux appropriés, permettre d'accroître la surface d'échange thermique avec ce flux d'air, et provoquent également de petites turbulences de l'air, ces phénomènes permettant d'améliorer l'évacuation de la chaleur engendrée dans la diode soudée sur la pièce 10.

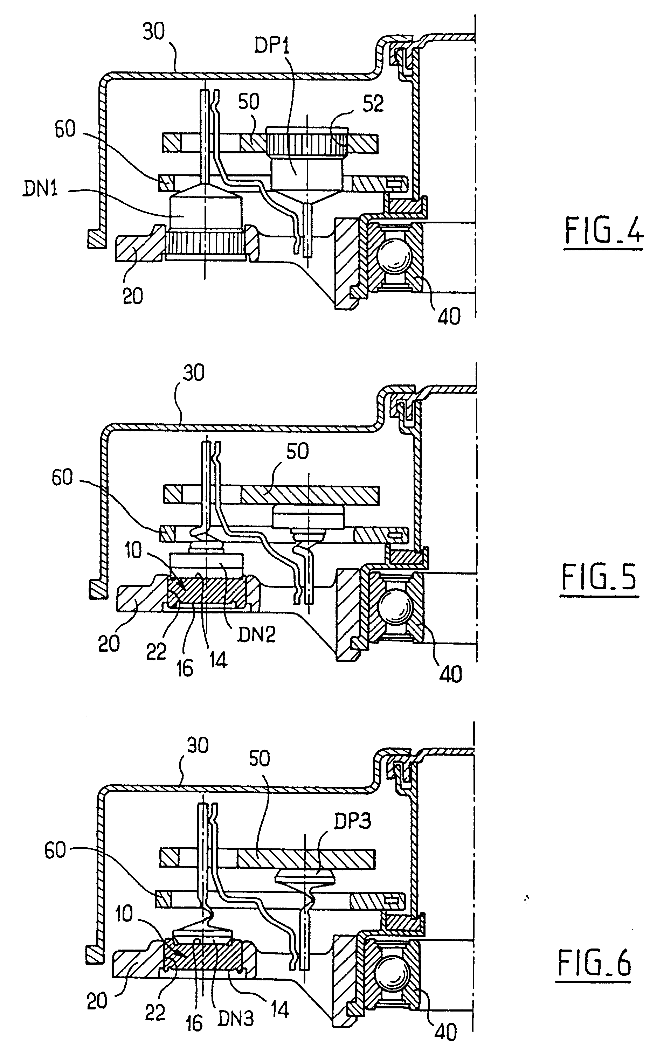

En référence maintenant à la figure 4, on a illustré une partie de la région arrière d'un alternateur. on a représenté le palier arrière 20 recevant un roulement d'arbre 40, un capot 30, un dissipateur positif 50 monté sur le palier arrière par des moyens électriquement isolants, et un connecteur 60 permettant d'assurer la connexion entre elles des six diodes de redressement d'un alternateur triphasé, ainsi que leur connexion aux enroulement de stator et aux bornes de sortie.

Dans le cas de la figure 4, les diodes DP1 et DN1, respectivement de côté positif et de côté négatif, sont du type emmanché à force.

Les diodes DN1 sont directement emmanchées dans des orifices ou culot 22 du palier arrière 20, tandis que les diodes DP1 sont emmanchées dans des orifices ou culots 52 du dissipateur positif 50.

La figure 5 représente la même vue, avec un pont redresseur constitué par des diodes à souder du type "Button can".

Les diodes positives DP2 sont soudées sur la surface du dissipateur positif 50, tandis que le palier arrière 20 reçoit dans ses orifices 22, dans l'orientation adaptée du type de diode (face 14 vers l'extérieur), des pièces d'adaptation 10 du type décrit en référence à la figure 1. Les diodes négatives DN2 sont soudées sur lesdites faces 14.

On observera ici que le palier arrière 20 est dans ce cas exactement identique à celui de la figure 4.

Dans le cas de la figure 6, le pont redresseur est constitué par des diodes à souder de type "Potted can". Les diodes positives DP3 sont là encore soudées directement à la surface du dissipateur positif 50, tandis que les diodes négatives DN3 sont soudées sur des pièces d'adaptation 10 identiques à celles de la figure 5, mais retournées sur 180° de manière à présenter à l'extérieur leur face 16, adaptée à ce type de diode. On comprend que, là encore, le palier arrière 20 peut être exactement, identique à celui des figures 4 et 5.

## Revendications

1. Alternateur, notamment pour véhicule automobile, du type comprenant des moyens dissipateurs de chaleur (20) comprenant un ou plusieurs orifices (22) conçus pour recevoir une ou plusieurs diodes par emmanchement, caractérisé en ce qu'il comprend une pièce d'adaptation (10) emmanchée respectivement dans le ou chaque orifice et présentant la forme générale d'un disque possédant un contour (12) permettant un tel emmanchement et au moins une face plane (14, 16) sur laquelle est soudée une diode à souder (DN2; DN3).

2. Alternateur selon la revendication 1, caractérisé en ce que les moyens dissipateurs sont constitués par un palier arrière métallique (20) de l'alternateur.

3. Alternateur selon l'une des revendications 1 et 2, caractérisé en ce que la ou chaque pièce d'adaptation comprend deux faces planes opposées (14, 16) permettant le soudage de l'un parmi deux types de diodes à souder (DN2; DN3).

4. Alternateur selon la revendication 3, caractérisé en ce que les deux faces planes opposées (14, 16) ont des diamètres différents.

5. Alternateur selon l'une des revendications 1 et 2, caractérisé en ce que la ou chaque pièce d'adaptation comprend une face plane unique (14) de soudage et, du côté opposé, des creux ou reliefs (18) de dissipation thermique.

6. Alternateur selon l'une des revendications 1 à 5, caractérisé en ce que la ou chaque face plane (14, 16) est en retrait, en étant circoncrite par un bourrelet (14b, 16b) de centrage de la diode.

7. Alternateur selon la revendication 6, caractérisé en ce qu'il est prévu entre la ou chaque face plane (14, 16) et le bourrelet associé une gorge périphérique (14a, 16a) de limitation des contraintes de cisaillement lors de la soudure.

8. Pièce d'adaptation pour un dissipateur de chaleur (20) de pont redresseur d'alternateur, notamment pour véhicule automobile, ladite pièce d'adaptation (10) étant caractérisée en ce qu'elle présente la forme générale d'un disque présentant un contour (12) tel qu'elle puisse être emmanché dans un orifice (22) du dissipateur destiné à l'emmanchement d'une diode, et au moins une face plane (14, 16) permettant le soudage d'une diode à souder (DN2; DN3).

9. Pièce d'adaptation selon la revendication 8, caractérisée en ce qu'elle comprend deux faces planes opposées (14, 16) permettant le soudage de l'un parmi deux types de diodes à souder (DN2; DN3).

10. Pièce d'adaptation selon la revendication 9, caractérisée en ce que les deux faces planes opposées (14, 16) ont des diamètres différents.

11. Pièce d'adaptation selon la revendication 8, caractérisée en ce qu'elle comprend une face plane unique (14) de soudage et, du côté opposé, des creux ou reliefs (18) de dissipation thermique.

12. Pièce d'adaptation selon l'une des revendications 8 à 11, caractérisée en ce que la ou chaque face plane (14, 16) est en retrait, en étant circoncrite par un bourrelet (14b, 16b) de centrage de la diode.

13. Pièce d'adaptation selon la revendication 12, caractérisée en ce qu'il est prévu entre la ou chaque face plane (14, 16) et le bourrelet associé une gorge périphérique (14a, 16a) de limitation des contraintes de cisaillement lors de la soudure.

## Patentansprüche

1. Wechselstromgenerator, insbesondere für Kraftfahrzeuge, umfassend Kühlkörpermittel (20) mit einer oder mehreren Öffnungen (22) zur Aufnahme einer oder mehrerer Dioden durch Einpressen, **dadurch gekennzeichnet,** daß er ein Anpaßstück (10) umfaßt, das in die bzw. in jede Öffnung eingepreßt ist und das die allgemeine Form einer Scheibe aufweist, die einen Umriß (12), der ein solches Einpressen ermöglicht, und wenigstens eine ebene Fläche (14, 16) besitzt, auf der eine Lötdiode (DN2; DN3) angelötet wird.

2. Wechselstromgenerator nach Anspruch 1, **dadurch gekennzeichnet,** daß die Kühlkörpermittel aus einem metallischen hinteren Lagerschild (20) des Wechselstromgenerators bestehen.

3. Wechselstromgenerator nach einem der Ansprüche 1 und 2, **dadurch gekennzeichnet,** daß das bzw. jedes Anpaßstück zwei gegenüberliegende ebene Flächen (14, 16) umfaßt, die das Anlöten einer der beiden Arten von Lötdioden (DN2; DN3) ermöglichen.

4. Wechselstromgenerator nach Anspruch 3, **dadurch gekennzeichnet,** daß die beiden gegenüberliegenden ebenen Flächen (14, 16) unterschiedliche Durchmesser haben.

5. Wechselstromgenerator nach einem der Ansprüche 1 und 2, **dadurch gekennzeichnet,** daß das Anpaßstück eine einzige ebene Lötfläche (14) und auf der gegenüberliegenden Seite Vertiefungen oder Erhebungen (18) für die Wärmeableitung umfaßt.

6. Wechselstromgenerator nach einem der Ansprüche 1 bis 5, **dadurch gekennzeichnet,** daß die bzw. jede ebene Fläche (14, 16) zurückversetzt ist, wobei sie durch einen Zentrierwulst (14b, 16b) für die Zentrierung der Diode umgrenzt ist.

7. Wechselstromgenerator nach Anspruch 6, **dadurch gekennzeichnet,** daß zwischen der bzw. jeder ebenen Fläche (14, 16) und dem zugehörigen Wulst eine Umfangsauskehlung (14a, 16a) zur Begrenzung der Scherspannungen beim Verlöten vorgesehen ist.

8. Anpaßstück für einen Kühlkörper (20) einer Gleichrichterbrücke eines Wechselstromgenerators, insbesondere für Kraftfahrzeuge, wobei das besagte Anpaßstück **dadurch gekennzeichnet** ist, daß es die allgemeine Form einer Scheibe aufweist, die einen solchen Umriß (12) besitzt, daß sie in eine Öffnung (22) des Kühlkörpers eingepreßt werden kann, die für das Einpressen einer Diode bestimmt ist, und wenigstens eine ebene Fläche (14, 16), die das Verlöten einer Lötdiode (DN2; DN3) ermöglicht.

9. Anpaßstück nach Anspruch 8, **dadurch gekennzeichnet,** daß es zwei gegenüberliegende ebene Flächen (14, 16) umfaßt, die das Anlöten einer der beiden Arten von Lötdioden (DN2; DN3) ermöglichen.

10. Anpaßstück nach Anspruch 9, **dadurch gekennzeichnet,** daß die beiden gegenüberliegenden ebenen Flächen (14, 16) unterschiedliche Durchmesser haben.

11. Anpaßstück nach Anspruch 8, **dadurch gekennzeichnet,** daß es eine einzige ebene Lötfläche (14) und auf der gegenüberliegenden Seite Vertiefungen oder Erhebungen (18) für die Wärmeableitung umfaßt.

12. Anpaßstück nach einem der Ansprüche 8 bis 11, **dadurch gekennzeichnet,** daß die bzw. jede ebene Fläche (14, 16) zurückversetzt ist, wobei sie durch einen Zentrierwulst (14b, 16b) für die Zentrierung der Diode umgrenzt ist.

13. Anpaßstück nach Anspruch 12, **dadurch gekennzeichnet,** daß zwischen der bzw. jeder ebenen Fläche (14, 16) und dem zugehörigen Wulst eine Umfangsauskehlung (14a, 16a) zur Begrenzung der Scherspannungen beim Verlöten vorgesehen ist.

## Claims

1. An alternator, in particular for a motor vehicle, the alternator being of the type comprising heat dissipator means (20) including one or more orifices (22) designed to receive one or more press-fit diodes, the alternator being characterized in that the, or each, orifice includes a respective adaptor (10) engaged as a press-fit therein, and being generally in the form of a disk having an outline (12) suitable for such press-fit engagement and at least one plane face (14, 16) on which a solder-mounting diode (DN2; DN3) is soldered.

2. An alternator according to claim 1, characterized in that the dissipator means are constituted by a metal back casing (20) of the alternator.

3. An alternator according to claim 1 or 2, characterized in that the, or each, adaptor includes two opposite plane faces (14, 16) enabling it to be soldered to either of two types of solder-mounting diode (DN2; DN3).

4. An alternator according to claim 3, characterized in that the two opposite plane faces (14, 16) are of different diameters.

5. An alternator according to claim 1 or 2, characterized in that the, or each, adaptor has a single plane face (14) for soldering and, on its opposite side, depressions or projections (18) for heat dissipation.

6. An alternator according to any one of claims 1 to 5, characterized in that the, or each, plane face (14, 16) is set back, being surrounded by a diode-centering flange (14b, 16b).

7. An alternator according to claim 6, characterized in that a peripheral groove (14a, 16a) is provided between the, or each, plane face (14, 16) and the associated flange, said groove limiting shear stresses during soldering.

8. An adaptor for a rectifier bridge heat dissipator (20) of an alternator, in particular for a motor vehicle, said adaptor (10) being characterized in that it is generally in the form of a disk having an outline (12) enabling it to be engaged as a press-fit in an orifice (22) of the dissipator that is designed to receive a diode as a press-fit, and at least one plane face (14, 16) enabling a solder-mounting diode (DN2; DN3) to be soldered thereto.

9. An adaptor according to claim 8, characterized in that it includes two opposite plane faces (14, 16) enabling it to be soldered to either of two types of solder-mounting diode (DN2; DN3).

10. An adaptor according to claim 9, characterized in that the two opposite plane faces (14, 16) are of different diameters.

11. An adaptor according to claim 8, characterized in that it includes a single plane face (14) for soldering, and, on the opposite side, recesses or projections (18) for heat dissipation.

12. An adaptor according to any one of claims 8 to 11, characterized in that the, or each, plane face (14, 16) is set back, being surrounded by a diode-centering flange (14b, 16b).

13. An adaptor according to claim 12, characterized in that a peripheral groove (14a, 16a) is provided between the, or each, plane face (14, 16) and the associated flange, the groove serving to limit shear stresses during soldering.
